# EUROPEAN PATENT SPECIFICATION

(11) **EP 0 795 041 B1**
(45) Date of publication and mention of the grant of the patent: **19.04.2000**
(21) Application number: 95940746.1
(22) Date of filing: 22.11.1995
(51) Int. Cl.: C23C 14/06, C23C 14/18, C23C 14/00

(54) **A PROCESS FOR IN-SITU DEPOSITION OF A Ti/TiN BARRIER METAL STACK**
VERFAHREN ZUM IN-SITU AUFTRAGEN EINER Ti/TiN ENTHALTENDEN METALLSPERRSCHICHT
PROCEDE DE DEPOT IN SITU D'UN PILE METALLIQUE D'ARRET EN TITANE/NITRURE DE TITANE

(30) Priority: 30.11.1994 US 347781
(43) Date of publication of application: 17.09.1997
(73) Proprietor: ADVANCED MICRO DEVICES INC., Sunnyvale, California 94088-3453 (US)
(72) Inventor: BESSER, Paul, R., Cupertino, CA 95014 (US); TRAN, Khanh, Q, San Jose, CA 95131 (US); ALVIS, Roger, L., Cupertino, CA 95014 (US); IACOPONI, John, A., San Jose, CA 95124 (US)
(74) Representative: Wright, Hugh Ronald
(86) International application number: US9515022
(87) International publication number: WO9617101

(56) References cited:
- EP-A- 0 598 422
- THIN SOLID FILMS, vol. 237, no. 1/02, 1 January 1994 pages 78-86, XP 000429587 MAHEO D ET AL 'MICROSTRUCTURE AND ELECTRICAL RESISTIVITY OF TIN FILMS DEPOSITED ON HEATED AND NEGATIVELY BIASED SILICON SUBSTRATES'
- THIN SOLID FILMS, vol. 215, no. 2, 14 August 1992 pages 152-161, XP 000291444 HULTMAN L ET AL 'INTERFACIAL REACTIONS IN SINGLE-CRYSTAL-TIN(100)/A1/POLYCRYSTALLINE -TIN MULTILAYER THIN FILMS'
- APPLIED PHYSICS LETTERS, vol. 61, no. 21, 23 November 1992 pages 2613-2615, XP 000324855 JOSHI R V ET AL 'COLLIMATED SPUTTERING OF TIN/TI LINERS INTO SUB-HALF-MICROMETER HIGH ASPECT RATIO CONTACTS/LINES'
- APPLIED PHYSICS LETTERS, vol. 61, no. 6, 10 August 1992 pages 654-656, XP 000290123 SHIH K K ET AL 'TI/TI-N HF/HF-N AND W/W-N MULTILAYER FILMS WITH HIGH MECHANICAL HARDNESS'
- THIN SOLID FILMS, vol. 217, no. 1 / 02, 30 September 1992 pages 31-37, XP 000358451 MASSIANI Y ET AL 'EFFECT OF A TITANIUM UNDERLAYER ON THE CORROSION BEHAVIOUR OF PHYSICALLY VAPOUR DEPOSITED TITANIUM NITRIDE FILMS'

## Description

### FIELD OF THE INVENTION

This invention relates to deposition methods for manufacturing integrated circuits, and particularly, to methods for depositing Titanium (Ti) and Titanium Nitride (TiN) stacks.

It shows be noted that - 1 torr = 133.3 N/m² and 1 Å = 10⁻¹⁰m.

### BACKGROUND

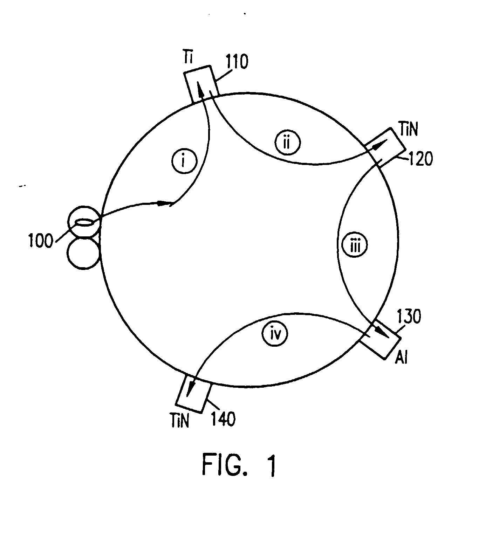

The results of recent electromigration studies suggest that a leading candidate for the next generation metal stack is Ti/TiN/Al/TiN. However, manufacturing such a metal stack presents some throughput problems. A typical vapor deposition system for forming metal stacks has four physical vapor deposition chambers. Thus, using a conventional process (where a separate deposition chamber is used for each layer), all four chambers would be used to deposit the stack. Figure 1 illustrates this conventional process. In step i, a wafer (also referred to as a "sample") 100 is moved into chamber 110 for Ti deposition. In step ii, wafer 100 is moved into chamber 120 for TiN deposition. In step iii, wafer 100 is moved into chamber 130 for A1 deposition. In step iv, wafer 100 is moved into chamber 140 for a second TiN deposition. As a result of this conventional process, the system's throughput is limited because each wafer must be moved in and out of a chamber at least four times to form the Ti/TiN/Al/TiN stack.

Additionally, because all four chambers are utilized for the metallization scheme, the flexibility of the system is greatly reduced The supported metallization scheme can only involve Ti, A1, and TiN.

Moreover, because the TiN deposited in chamber 120 has a special clamp that leaves large areas on wafer 100 uncovered with TiN, the system of Figure 1 cannot accommodate TiN/Tungsten barrier depositions because typical barrier depositions must cover most (if not all) of the wafer surface (typically within 2 mm of the edge of wafer 100). As a result, the subsequently deposited tungsten will only deposit on TiN and, thus, will adhere to wafer 100. However, because all the chambers used to deposit the Ti/TiN/Al/TiN stack have special clamps, the system cannot be used for these barrier depositions.

Further, in a conventional process, the TiN chamber requires Ti pasting to prevent TiN from flaking off the interior surface of the chamber. Consequently, Ti pasting further decreases throughput.

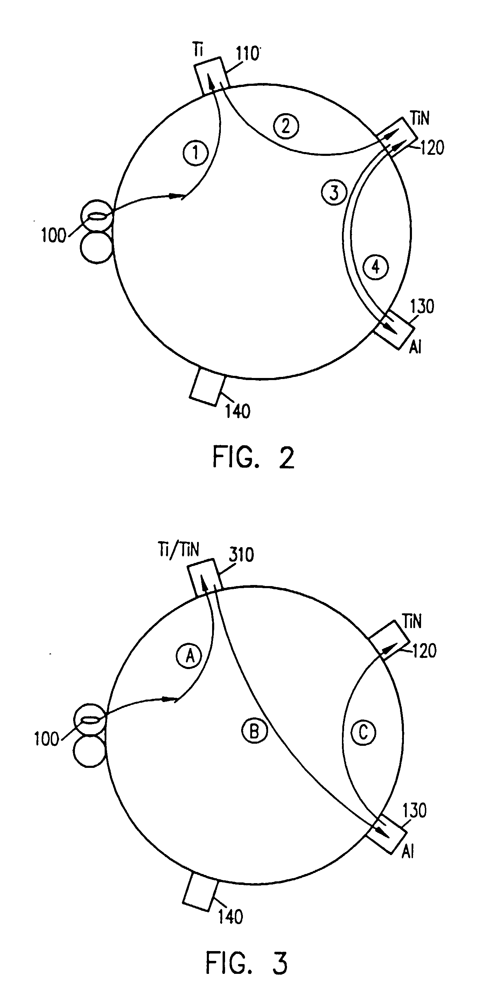

Figure 2 illustrates an alternative conventional process. In step 1, wafer 100 is moved into chamber 110 for Ti deposition. In step 2, wafer 100 is moved into chamber 120 for TiN deposition. In step 3, wafer 100 is moved into chamber 130 for A1 deposition. In step 4, wafer 100 is moved back into chamber 120 for another TiN deposition. This process has limited throughput not only because there are four handling steps (i.e., moving the sample into and out of a chamber), but also because the chambers cannot be used concurrently due to the requirement that chamber 120 be available for the second TiN deposition of step 4.

Reference may be made to EP-A-0 598 422 which discloses a method of forming a Ti and a TiN layer on a semiconductor body by a sputtering process.

### SUMMARY

According to the present invention as claimed in claim 1, a single chamber of a vapor deposition system is used to deposit both Ti and TiN. A Ti layer is deposited on the sample using a noncollimated process. N₂ gas is then introduced in the chamber. A TiN layer is then deposited over the Ti layer, and afterwards, the chamber is evacuated.

Because both Ti and TiN are deposited in the same chamber, the process requires one less handling step than the conventional process, thereby increasing throughput. Further, the need for Ti pasting of a TiN chamber is eliminated, thereby further increasing throughput. Still further, an A1 layer deposited on the TiN layer produced by the present process can have improved texture and grain size relative to an A1 layer deposited on the TiN layer of the conventional process.

### BRIEF DESCRIPTION OF THE DRAWINGS

Figure 1 illustrates a process flow of a conventional Ti/TiN/Al/TiN process using a separate vapor deposition chamber for each layer.

Figure 2 illustrates a process flow for an alternative conventional Ti/TiN/Al/TiN process.

Figure 3 illustrates the process flow for Ti/TiN/Al/TiN deposition using one embodiment of the present invention in a deposition system having four physical vapor deposition chambers.

Figure 4 shows a Ti/TiN vapor deposition system according to one embodiment of the present invention.

Figure 5 shows a cross-sectional view of a Ti/TiN/Al/TiN stack.

### DETAILED DESCRIPTION

Figure 3 illustrates the process flow for Ti/TiN/Al/TiN deposition using one embodiment of the present invention in a deposition system having four physical vapor deposition chambers. In step A, wafer 100 is moved into a chamber 310 for Ti/TiN deposition. A robot arm (not shown) is used to move wafer 100 into and out of the chambers. In step B, wafer 100 is moved into chamber 130 for A1 deposition. In step C, wafer 100 is moved into chamber 120 for TiN deposition. Throughput is increased in the process of Figure 3 as compared to the processes of Figures 1 and 2 because the system of Figure 3 requires one fewer handling step. Further, the Ti/TiN step A is self-pasting because the chamber 310 is pasted by the Ti deposition of the next wafer moved into chamber 310 for Ti/TiN deposition. Still further, a fourth chamber is left available for barrier depositions without disrupting concurrent use of the remaining three chambers.

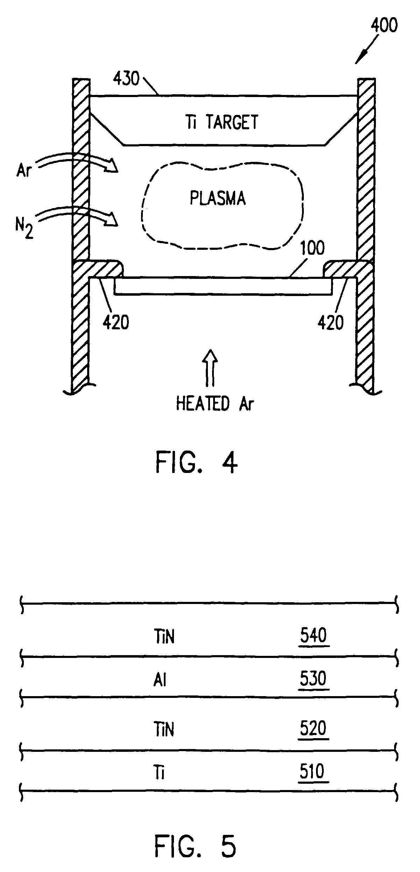

Figure 4 shows a vapor deposition system 400 according to one embodiment of the present invention. In vapor deposition system 400, wafer or sample 100 is held approximately 52 mm from Ti target 430 by a heater clamp 420. For this embodiment, the steps for "same chamber" Ti/TiN deposition are summarized in Table 1 below.

**TABLE 1**

| Step | BSP | Preheat | Dep | Gas | Dep | BSP |
|---|---|---|---|---|---|---|
| Time (sec) | 2 | 15 | 9.3 | 5.0 | 34 | 4.0 |
| Power (W) | 0 | 0 | 3000 | 0 | 6500 | 0 |
| Power Rate (W/s) | 0 | 0 | 3000 | 0 | 6500 | 0 |

| Gas Flow | | | | | | |
|---|---|---|---|---|---|---|
| Heated | -2 PV | 15 | 15 | 15 | 15 | -2 PV |
| Ar | | | | | | |
| Ar | | | | 34 | 34 | -2 PV |
| N₂ | | | | 90 | 90 | -2 PV |

In the first BSP step, the gas lines for providing various gases to the chamber are closed and the heated Ar gas line is evacuated to the final valve of the gas line to a pressure of approximately 10⁻⁸ Torr (-2 PV). As a result, the chamber is evacuated to a base pressure of approximately 10⁻⁸ Torr. This step takes approximately 2 seconds to complete.

In the Preheat step, sample 100 is placed against the heater clamp 420, and 15 SCCM (standard cubic centimeters per minute) of heated Ar gas is supplied into the chamber below sample 100 to preheat sample 100 and maintain a pressure differential to keep sample 100 in contact with heater clamp 420. In this embodiment, sample 100 is heated to approximately 250 °C, but any temperature may be used depending on the coverage and film quality desired. Typically, a temperature in the range of 25-450 °C is suitable. A target-to-sample spacing of 52 mm is maintained. This spacing is the optimized spacing for TiN deposition for the power and magnet (not shown) in this process. Ar gas is introduced into the chamber above the sample for generating a plasma. In this embodiment, 50 SCCM of Ar gas is used, although any flow of Ar gas can be used so long as enough Ar gas is provided to create a suitable plasma. Typically, an Ar gas flow in the range of 40-100 SCCM is suitable. This step takes approximately 15 seconds.

In the first Dep step, Ti is deposited on sample 100. A plasma is created in the chamber by applying a voltage across the Ti target 430 and sample 100. In this embodiment, a 3000 W plasma is used, although any power level can be used depending on the sputtering rate and coverage desired. Typically, a power level greater than 1000 W is suitable. A suitable plasma pressure can be anywhere from a few to several hundred mTorr. No collimator is necessary, which if used, would slow down the deposition process thereby reducing throughput. The Ar and heated Ar gas flows are maintained and a 250Å thick layer of Ti is deposited on sample 100 after approximately 9.3 seconds.

In the Gas step, the plasma is terminated by terminating the power, and N₂ gas is introduced into the chamber. As a result, TiN is formed on said target (said Ti target 430 is placed in a "Nitrided" mode for TiN deposition). In this embodiment, 90 SCCM of N₂ flow is used, although any gas flow can be used that provides sufficient N under the existing conditions to place Ti target 430 into nitrided mode. Typically, a N₂ gas flow in the range of 60 and 200 SCCM is suitable. The Ar flow is reduced to a lower value (34 SCCM).

In the second Dep step, TiN is deposited on sample 100. A plasma is created by applying a voltage across the nitrided Ti target 430 and sample 100. In this embodiment, a 6500 W plasma is used because of the lower sputtering rate of TiN (compared to Ti). Again, any power level can be used depending on the sputtering rate and coverage desired. Typically, a power level greater than 5000 W is used to achieve a suitable sputtering rate. The N₂, Ar and heated Ar gas flows are maintained and after approximately 34 seconds, 800Å of TiN is deposited on sample 100.

In the second BSP step, the plasma is terminated and the gas lines closed. The Ar and N₂ gas lines are evacuated to the final valve of the gas line, and consequently, the chamber is no longer flooded with N₂ gas. Thus, Ti target 430 is left in a semi-nitrided mode. This step takes approximately 4 seconds to complete.

Figure 5 shows a cross-sectional view of a Ti/TiN/Al/TiN stack produced by the above-described embodiment. First, Ti layer 510 is deposited on the sample to a thickness of approximately 250Å. Then, in the same chamber, TiN layer 520 is deposited on top of Ti layer 510 to a thickness of approximately 800Å. The sample is moved to another chamber where Al layer 530 is deposited on top of TiN layer 520 to a thickness of approximately 4000Å. The sample is then moved to a third chamber where TiN ARC layer 540 is deposited on Al layer 530.

The same chamber Ti/TiN deposition process is observed to have a "first wafer" effect (i.e., the Ti film of the first wafer is thicker) when the layer deposited prior to the Ti layer was also Ti. When the Ti layer for the first wafer is deposited from a metallic Ti target, the Ti layer is relatively thick. In contrast, the Ti layer for the second wafer in this process will be deposited from a nitrided Ti target. Consequently, the Ti layer for the second wafer will be relatively thin because the sputtering rate for TiN (in the surface of the nitrided Ti target) is lower than the sputtering rate of Ti from a metallic Ti target.

Also observed for the same chamber Ti/TiN deposition process is that the Ti/TiN layer formed thereby is slightly different than a Ti/TiN layer formed by depositions in separate chambers. The main differences are that the Ti layer from the same chamber Ti/TiN deposition has degraded uniformity (i.e., the variation in the layer's thickness is increased) and incorporation of approximately 3 to 5 at% N.

The degradation in uniformity is attributable at least in part to the 52 mm TiN target-to-sample spacing (rather than the optimal 43 mm Ti target-to-sample spacing) used in the same chamber Ti/TiN deposition process. Separate chamber Ti/TiN deposition has an observed sheet resistance uniformity of approximately 1.5% 1σ as compared to approximately 3.1% 1σ for same chamber Ti/TiN deposition. A uniformity of 3.1% 1σ is acceptable for many applications.

Moreover, when Al is included in the stack, the observed sheet resistance uniformity is approximately 1.4% 1σ, which is excellent under current standards. Further, studies show that the degraded uniformity of the Ti/TiN layer does not substantially compromise (and in some aspects improves) the quality (e.g., grain size, texture, and electromigration properties) of the Al layer in the Ti/TiN/Al/TiN stack. For example, the Al layer's observed crystallographic texture as determined using x-ray diffraction is slightly stronger for Al deposited on "same chamber" Ti/TiN (volume fraction <111> = 0.92) than for separate chamber Ti/TiN (volume fraction <111> = 0.89). Also, the observed average grain size of the Al layer (Al-1%Cu) as determined using transmission electron microscopy was 0.85 µm ±0.35 µm for Al deposited on same chamber Ti/TiN and 0.77 µm ±0.35 µm for Al deposited on separate chamber Ti/TiN.

The foregoing has described the principles and preferred embodiments of the present invention. However, the invention should not be construed as being limited to the particular embodiments described. For example, the deposition time, temperature, plasma power, gas flows and spacing can be varied to produce Ti or TiN films of different thickness and/or quality at different rates and/or efficiency. Thus, above-described embodiments should be regarded as illustrative rather than restrictive. Variations can be made to those embodiments by workers skilled in the art without departing from the scope of the present invention as defined by the following claims.

## Claims

1. A method for depositing Ti and TiN on a sample in a single physical vapor deposition chamber, said chamber containing a Ti target, said method comprising the steps of:
sputtering Ti onto said sample; *characterised by*
subsequently introducing a gas into said chamber to form TiN on said target; and
sputtering TiN onto the Ti on said sample.

2. The method of Claim 1, further comprising the step of removing said gas from said chamber thereby placing said target in a semi-nitrided mode.

3. The method of Claim 1, wherein said step of introducing a gas comprises the step of introducing N₂ gas into said chamber.

4. The method of Claim 3. wherein said step of introducing N₂ gas comprises the step of introducing 70 to 90 SCCM of N₂ gas into said chamber.

5. The method of Claim 1, wherein said step of sputtering Ti comprises the step of creating a plasma in said chamber between said target and said sample.

6. The method of Claim 5, wherein said step of creating a plasma comprises the steps of: introducing Ar gas into said chamber: and creating a plasma using at least 1000 W of power.

7. The method of Claim 1, wherein said step of sputtering TiN comprises the steps of:
introducing N₂ gas into said chamber; and
creating a plasma in said chamber between said target and said sample.

8. The method of Claim 7, wherein said step of introducing N₂ gas comprises the step of introducing 70 to 110 SCCM of N₂ gas into said chamber, and said step of creating a plasma comprises the step of creating a plasma using at least 5000 W of power.

9. The method of Claim 1, further comprising the step of preheating said sample.

10. The method of Claim 9, wherein said step of preheating said sample comprises the step of heating said sample to a temperature of 25 to 450 °C at least in part by using heated Ar gas.

11. The method as claimed in any of claims 1 to 10, including the further steps of:
depositing a layer of Al on said TiN layer deposited in said TiN sputtering step,
and depositing a layer of TiN on said Al layer deposited in said Al depositing step. said TiN layer deposited on said Al layer serving as an anti-reflective coating.

## Patentansprüche

1. , Verfahren zum Aufbringen von Ti und TiN auf eine Probe in einer einzelnen physikalischen Aufdampfungskammer, die ein Ti-Target aufweist, wobei das Verfahren die folgenden Schritte aufweist:
Sputtern von Ti auf die Probe;
gekennzeichnet durch
das anschließende Einleiten eines Gases in die Kammer zur Bildung von TiN auf dem Target, und
Sputtern von TiN auf das Ti auf der Probe.

2. Verfahren nach Anspruch 1, ferner mit dem Schritt des Entfernens des Gases aus der Kammer, wodurch das Target in einen semi-nitrierten Zustand versetzt wird.

3. Verfahren nach Anspruch 1, bei dem der Schritt des Einleitens eines Gases den Schritt des Einleitens von N₂-Gas in die Kammer umfaßt.

4. Verfahren nach Anspruch 3, bei dem der Schritt des Einleitens von N₂-Gas den Schritt des Einleitens von 70 bis 90 sccm N₂-Gas in die Kammer umfaßt.

5. Verfahren nach Anspruch 1, bei dem der Schritt des Sputterns von Ti den Schritt des Erzeugens eines Plasmas in der Kammer zwischen dem Target und der Probe umfaßt.

6. Verfahren nach Anspruch 5, bei dem der Schritt des Erzeugens eines Plasmas die Schritte des Einleitens von Ar-Gas in die Kammer und des Erzeugens eines Plasmas unter Verwendung von wenigstens 1000 W Energie umfaßt.

7. Verfahren nach Anspruch 1, bei dem der Schritt des Sputterns von TiN die Schritte des Einleitens von N₂-Gas in die Kammer und des Erzeugens eines Plasmas in der Kammer zwischen dem Target und der Probe umfaßt.

8. Verfahren nach Anspruch 7, bei dem der Schritt des Einleitens von N₂-Gas den Schritt des Einleitens von 70 bis 110 sccm N₂-Gas in die Kammer und der Schritt des Erzeugens des Plasmas den Schritt des Erzeugens von Plasma unter Verwendung von wenigstens 5000 W Energie umfaßt.

9. Verfahren nach Anspruch 1, ferner mit dem Schritt des Vorheizens der Probe.

10. Verfahren nach Anspruch 9, bei dem der Schritt des Vorheizens der Probe den Schritt des wenigstens teilweisen Erwärmens der Probe auf eine Temperatur zwischen 25° und 450° C unter Verwendung erwärmten Ar-Gases umfaßt.

11. Verfahren nach einem der Ansprüche 1 bis 10, mit den weiteren Schritten
des Aufbringens von Al auf die im TiN-Sputterschritt aufgebrachte TiN-Schicht,
und des Aufbringens einer TiN-Schicht auf der im Al-Aufbringschritt aufgebrachten Al-Schicht, wobei die auf der Al-Schicht aufgebrachte TiN-Schicht als Anti-Reflexionsschicht dient.

## Revendications

1. Procédé de dépôt de Ti et de TiN sur un échantillon dans une seule chambre de dépôt physique en phase vapeur, ladite chambre contenant une cible de Ti, ledit procédé comprenant les étapes consistant à :
pulvériser Ti sur ledit échantillon ; caractérisé par
l'introduction ultérieure d'un gaz dans ladite chambre pour former du TiN sur ladite cible ; et
la pulvérisation de TiN sur le Ti présent sur ledit échantillon;

2. Procédé selon la revendication 1, comprenant, de plus, l'étape consistant à éliminer ledit gaz de ladite chambre de façon à placer ladite cible dans un mode semi-nitruré.

3. Procédé selon la revendication 1, dans lequel ladite étape consistant à introduire un gaz comprend l'étape consistant à introduire du gaz N₂ dans ladite chambre.

4. Procédé selon la revendication 3, dans lequel ladite étape d'introduction de gaz N₂ comprend l'étape consistant à introduire 70 à 90 SCCM de gaz N₂ dans ladite chambre.

5. Procédé selon la revendication 1, dans lequel ladite étape de pulvérisation de Ti comprend l'étape consistant à créer un plasma dans ladite chambre entre ladite cible et ledit échantillon.

6. Procédé selon la revendication 5, dans lequel ladite étape de création de plasma comprend les étapes consistant à :
introduire du gaz Ar dans ladite chambre ; et
créer un plasma en utilisant au moins une puissance de 1000 W.

7. Procédé selon la revendication 1, dans lequel ladite étape de pulvérisation de TiN comprend les étapes consistant à :
introduire du gaz N₂ dans ladite chambre ; et
créer un plasma dans ladite chambre entre ladite cible et ledit échantillon.

8. Procédé selon la revendication 7, dans lequel ladite étape d'introduction de gaz N₂ comprend l'étape consistant à introduire 70 à 110 SCCM de gaz N₂ dans ladite chambre, et ladite étape de création de plasma comprend l'étape consistant à créer un plasma en utilisant une puissance d'au moins 5000 W.

9. Procédé selon la revendication 1 comprenant, de plus, l'étape de préchauffage dudit échantillon.

10. Procédé selon la revendication 9, dans lequel ladite étape de préchauffage dudit échantillon comprend l'étape consistant à chauffer ledit échantillon à une température de 25 à 450° C au moins en partie en utilisant du gaz Ar chaud.

11. Procédé selon l'une quelconque des revendications 1 à 10, comprenant les étapes supplémentaires consistant à :
déposer une couche d'Al sur ladite couche de TiN déposée dans ladite étape de pulvérisation de TiN,
et déposer une couche de TiN sur ladite couche d'Al déposée dans ladite étape de dépôt d'Al, ladite couche de TiN déposée sur ladite couche d'Al servant de revêtement anti-reflet.
